(19) Europäisches Patentamt
European Patent Office
Office européen des brevets

(11) **EP 4 345 473 A1**

(12) **EUROPEAN PATENT APPLICATION**

(43) Date of publication:
**03.04.2024 Bulletin 2024/14**

(21) Application number: **22199322.3**

(22) Date of filing: **02.10.2022**

(51) International Patent Classification (IPC):
**G01R 33/032** (2006.01)      **G01R 33/26** (2006.01)

(52) Cooperative Patent Classification (CPC):
**G01R 33/032; G01C 19/00; G01R 33/26**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Universität Basel
4001 Basel (CH)**

(72) Inventors:
• **MALETINSKY, Patrick
4001 Basel (CH)**
• **BÜRGLER, Beat
4001 Basel (CH)**
• **SJÖLANDER, Tobias
4001 Basel (CH)**

(74) Representative: **Schulz Junghans
Patentanwälte PartGmbB
Großbeerenstraße 71
10963 Berlin (DE)**

(54) **AN ALL-OPTICAL QUANTUM SENSOR FOR MAGNETIC FIELDS**

(57)      The invention relates to a quantum spin-based optical sensor system (1) for measuring a characteristic quantity in magnetometry or gyroscopy, the system (1) comprising the following components:
- a crystal (2) comprising a photoluminescent color-center (20) having a defect-axis (200) along an axis of symmetry of the color-center (20), wherein the color-center (20) comprises a defect-atom (21) arranged on the defect-axis (200), wherein the defect-atom (21) exhibits a nuclear spin that is polarizable with light (100), and wherein the color-center (20) exhibits a nuclear spin-dependent photoluminescence characteristic,
- a light source (3) configured and arranged to excite the color-center (20) with light (100),
- a detector (4) configured and arranged to record a photoluminescence signal (101) emitted from the color-center (20),
a field-generating device (5) configured and adapted to generate a static magnetic field, wherein a magnetic field vector (500) of the generated magnetic field at the crystal (2) encloses an angle ($\theta$) with the defect-axis (200) with a magnitude in the range of 0.1° or greater.

Fig. 3

EP 4 345 473 A1

**Description**

The invention relates to a quantum spin-based optical sensor system for measuring a characteristic quantity in magnetometry or gyroscopy.

Spin-based quantum sensors can be employed to measure a wide range of physical quantities, including magnetic or electric fields, temperature, or rotary motion. This abundance of potential observables, combined with their high sensitivity at the nanoscale makes quantum sensors highly interesting for many fields of application, such as life sciences, geo sciences, navigation and material sciences

For example, Nitrogen-Vacancy (NV) centers in diamond are a particularly promising platform for such spin-based quantum sensing applications, because they feature a single electronic spin with long coherence times even at room temperature. Upon optical excitation with green light, the NV-center emits spin-dependent red photoluminescence, which enables all-optical electron spin readout. At the same time, such optical excitation pumps the NV electron spin into a specific spin-eigenstate, enabling all-optical spin initialization. Microwave (MW) driving fields, i.e. time-varying magnetic fields can then be used to coherently control the spin, and create arbitrary superposition states. These combined properties form the basis of almost all established spin-based approaches to sensing.

The NV electron spin is inherently coupled to the nuclear spin of its nitrogen atom - a spin which exhibits even longer decay and coherence times compared to the NV electron spin and that therefore provides another interesting resource for quantum technology applications. Specifically, the NV nuclear spin has been exploited as a quantum register for quantum communication and enhanced spin readout techniques, but it also offers interesting opportunities for sensing, be it for magnetometry or for gyroscopy.

Typically, such nuclear spin sensing schemes rely on the resonant coupling of the NV spin and the nuclear nitrogen spin at a magnetic field of about 500 G, where spin flip-flop processes occur in the NV's orbital excited state at the so-called excited state level anti-crossing (ESLAC). It has been shown that optical pumping in the vicinity of the ESLAC results in nuclear spin hyperpolarization, and that - by virtue of the same mechanism - the NV center shows a nuclear spin-state dependent rate of transient photoluminescence. As a result, optical pumping close to the ESLAC enables both all-optical readout of the nuclear spin state and initialization into a nuclear spin eigenstate, which, together with radio-frequency (RF) driving, forms the basis for most nuclear spin-based sensing schemes.

The ubiquitous need for MW or RF driving in spin-based quantum sensing, however, forms a severe limitation for many applications, since the concomitant radiation can adversely affect investigated samples. Furthermore, for integrated or portable sensing devices, MW or RF delivery increases power-consumption, overall complexity and thereby size and cost of the system.

Wickenbrock et al. [1] teaches a system that is configured to address a ground state level anti-crossing (GSLAC) of an NV-center. While this system omits the use of a MF or RF driving, but aligns a static magnetic field of a field-generating device along the defect-axis of the NV-center, the magnetic field strength is determined optically from a brightness of the photoluminescence of the NV-center that may drift or vary depending on various difficult to control parameters.

It is goal of the present invention to provide a system and a measurement method that is devoid of any of the drawbacks of systems and methods known in the art.

The object is achieved by the device having the features of claim 1.

Advantageous embodiments are described in the dependent claims.

According to a first aspect of the invention, a quantum spin-based optical sensor system for measuring a characteristic quantity in magnetometry, gyroscopy or another sensing application, is disclosed, wherein the system comprises the following components:

- a crystal comprising a photoluminescent color-center having a defect-axis along an axis of symmetry of the color-center, wherein the color-center comprises a defect-atom arranged on the defect-axis, wherein the defect-atom exhibits a nuclear spin that is polarizable with light, particularly with light in a wavelength range between 200 nm and 2.5 micron, and wherein the color-center exhibits a nuclear spin-dependent photoluminescence characteristic,
- a light source configured and arranged to excite the color-center, particularly in the wavelength range,
- a detector configured and arranged to record a nuclear spin-dependent signal from the color-center, particularly at least one value of the signal from the color-center, for obtaining at least a periodic variation of the photoluminescence signal over time,
- a field-generating device configured and adapted to generate a static magnetic field, wherein a magnetic field vector of the generated magnetic field at the crystal encloses an angle with the defect-axis with a magnitude with a magnitude greater than 0.1° such that the nuclear spin-dependent signal exhibits a periodic variation, after the color-center has been optically initialized by the light source into a coherent quantum superposition state, particularly, wherein said coherent quantum superposition state is not an eigenstate of the nuclear spin of the defect-atom.

The system according to the first aspect of the invention is configured to measure the characteristic quantity e.g. a magnetic field, such as the magnetic field strength, a rotation, such as an angular velocity, an acceleration, or an orientation of the system, or any other quantity affecting a quantum phase acquired by a quantum superposition state of the defect atom that may be optically initialized and optically read-out by the system according to the invention.

The term 'crystal' in the context of the current application particularly refers to a solid compound consisting of atoms or molecules that are arranged in a regular crystal lattice. The crystal lattice may comprise a plurality of lattice axes. The defect atom may be arranged on the crystal lattice and allow the crystal symmetry to remain intact or form a lattice and symmetry breaking at its location in the crystal.

The defect-atom may be part of a defect, that comprises the defect-atom and one or more vacancies and/or one or more additional defect-atoms.

The color-center may comprise a defect atom that replaces one or more crystal lattice atoms.

The term 'nuclear spin-dependent photoluminescence characteristic' particularly refers to a photoluminescence of the color-center that changes one or more properties, such as an absorption and/or an emission rate, a photoluminescence decay time, an emission and/or an absorption wavelength in a spin-state dependent manner. This allows to optically receive information on the spin-state of the defect atom. Also, the photoluminescence characteristic may be readout by means of an induced current or voltage change in the crystal.

The term 'color-center' in the context of the current specification particularly, refers to a 'Farbzentrum', wherein according to the invention, the color-center comprises at least one defect-atom and that defines the defect-axis by means of a symmetry axis of the color-center

The symmetry axis of the color-center may lie in a crystal lattice structure having a symmetry.

Particularly, the defect-axis is an imaginary line extending through the defect-atom along a symmetry axis of the color-center. Typically, the defect-axis is aligned with one of the crystal axes.

Furthermore, a color-center according to the current specification exhibits photoluminescent characteristics, i.e. when excited with light it emits photoluminescent photons.

The invention is designed to make use of at least the nuclear spin of the defect-atom.

For this, the system comprises a light source configured to excite photoluminescence from the color-center and thereby polarizing the nuclear spin of the defect-atom by means of an ESLAC and/or a GSLAC.

The inventors have realized that rather than perfectly aligning the static magnetic field from the field-generating device with the defect-axis, it is advantageous to provide a static transversal magnetic field component with respect to the defect-axis. This results in a magnetic field of the field-generating device, that is slightly tilted with respect to the defect-axis, wherein the angle enclosed by the magnetic field vector of said magnetic field is in the above-mentioned range. The range determines itself depending on the specific crystal and color-center. It is however common to all the color-center exhibiting a nuclear-spin-dependent photoluminescence characteristic that they may be initialized into the coherent quantum superposition state, which results in a precession of the nuclear spin once the excitation and thus initialization is turned off. The periodic variation, such as the frequency or period of the precession in turn depends on the magnetic field. In order to determine the period variation of the nuclear spin-dependent signal, a value of the nuclear spin-dependent signal may be recorded, e.g. optically of electrically, after some time (free-precession interval) after the excitation stopped. This procedure may be repeatedly executed for varying durations of the free-precession interval. Due to the periodic variations the recorded value depends on the duration of the free-precession interval. It is possible to conclude on the frequency or at least on a change of the frequency of the periodic variation by recording two or more values for different free precession intervals.

In contrast, a magnetic field corresponding to the ESLAC or the GSLAC and that is aligned with the defect-axis polarizes the nuclear spin of the defect-atom into an eigenstate, which in turn would not give rise to the observation of the periodically varying signal. According to the invention, the additional transverse component of the static magnetic field allows to initialize the nuclear spin of the defect-atom into the coherent superposition state that in turn allows a decidedly more robust sensing of the characteristic quantity due to the induced precession that is reflected in the photoluminescence characteristic of the color center.

Therefore, the arrangement of the static magnetic field allows to address fundamentally different spin states, as the oblique (with respect to the defect-axis) magnetic field vector induces a precession of the nuclear spin around the magnetic field vector. This precession in turn gives rise to a periodically varying photoluminescence signal emitted from the color-center. The period and/or frequency of the photoluminescence signal may be directly related to the characteristic quantity such as the magnetic field strength. The characteristic quantity, e.g. an external magnetic field (not generated by the field-generating device) or the angular velocity that is to be measured by the system will alter the period of the signal. This allows for a robust determination of the magnetic field strength, as it is independent of brightness, emission rate, or intensity and therefore not prone to drift.

It is noted that the system is devoid of a MW or RF driving, solely requires a static, i.e. constant magnetic field enclosing an angle with respect to the defect-axis.

The field-generating device may comprise a permanent magnet or an electromagnet. The term 'static' in the context of the current specification therefore particularly relates to times that are used for measuring, therefore, the magnet may be switchable such as to preserve energy, when the system is not used for measuring.

As such that system allows for a robust, all-optically driven measurement system with a low power consumption (as compared to the system known in the art).

For a particularly energy-efficient system the light source may comprise one or more LEDs or Laser diodes.

According to another embodiment of the invention, the system is configured to determine the characteristic quantity by executing the measurement steps of:

- During a spin initialization interval, exciting the color-center with light of the light source and exposing the crystal with the color-center to the static magnetic field of the field-generating device, such that the nuclear spin of the defect-atom is initialized, i.e. optically pumped, into the coherent quantum superposition state, particularly wherein the coherent quantum superposition state differs from an eigenstate of the nuclear spin of the defect-atom, more particularly wherein the crystal is exposed also to the characteristic quantity,
- During a free precession interval of the coherent quantum superposition state of the nuclear spin of the defect-atom, exposing the color-center to the magnetic field of the field-generating device and the characteristic quantity to be measured, while suppressing, e.g. omitting or reducing excitation of the color-center with light from the light source,
- During a nuclear spin readout interval, exposing the crystal with the color-center to the magnetic field of the field-generating device, exciting the color-center with light from the light source, and recording at least one value of the nuclear spin-dependent signal from the crystal with the detector, particularly, wherein the crystal with the color center is also exposed to the characteristic quantity.

In case the characteristic quantity is the magnetic field to be measured, the magnetic field should ideally be static or quasi-static. The latter refers to a varying magnetic field, wherein a characteristic time scale of the variation of the magnetic field is slower than the precession and the probing interval.

In the art, where the sensing direction is aligned with the defect-axis, a magnetic field to be measured that is aligned with the defect-axis as well as zero magnetic field will both result in an initialization of the nuclear spin state into an eigenstate of the effective ground state Hamiltonian. Therefore, for such fields, no nuclear spin precession occurs - and hence no time-varying signal - once optical pumping is turned off, i.e. during the free precession interval. Therefore, in the art it is fundamentally not possible to read out a periodic varying signal, such as a photoluminescence signal, without using MW or RF driving. In order to initialize the coherent quantum superposition state, the static magnetic field has to be tilted with respect to the defect-axis.

The recording of the signal, that may be the photoluminescence signal or an electrical signal from the crystal, be done in a series of single value measurements during the spin readout interval. For this reason, the measurement steps may be repeated with varying durations of the free-precession interval, such as to obtain (periodic variations dependent) varying values for each repetition. This in essence samples the periodic variation of the signal. Having two values for two different free precession interval durations may allow already a determination of a frequency of the periodic variation.

This embodiment elaborates on an all-optical preparation of the nuclear spin in the precessing state, i.e. the coherent quantum superposition state.

For the system to be configured for the measurement steps of this embodiment, the system may comprise additional components, such as, a switch, a timer, and/or one or more electronic circuits, such as an integrated circuit or a microchip, arranged and configured to control the light source, the field-generating device, and the detector. Particularly, these components may be configured to turn the light of the light source on and off for predefined or selectable time intervals.

During the free-precession interval, the crystal is particularly shielded from any light. This may be facilitated by means of a sensor head housing.

According to another embodiment of the invention, the system is configured to execute the spin-initialization interval in uninterrupted succession after the nuclear spin read-out interval, particularly wherein for determining the characteristic quantity only the steps of the spin-initialization interval, the free precession interval, and the nuclear spin readout interval are executed.

This embodiment allows for particularly short measurement times and a reduced complexity for controlling the system.

According to another embodiment of the invention, the system comprises an evaluation module configured to determine the periodic variation from the recorded nuclear spin-dependent signal, wherein the periodic variation is determined by executing the measurement steps for two or more different durations of the free precession interval and by determining the periodic variation from the recorded values of the nuclear spin-dependent signal, and to determine from the periodic variation the characteristic quantity, particularly a magnetic field strength, particularly a magnetic field strength of the magnetic field to be measured.

This allows to determine the periodic variation of the recorded signal, photoluminescent and/or electric, as a function of a duration of the precession interval.

The evaluation module may be configured to determine the magnetic field strength only from the periodic variation of the signal.

According to another embodiment of the invention, the magnitude of the angle is in the range of 0.1° to 10°, particularly in the range of 0.1° to 5°, more particularly in the range of 0.1° to 3°.

It is important to note that while in some instances the angle may be only slightly different from 0°, the effect is strikingly different to a perfect alignment of 0° as elaborated above.

According to another embodiment of the invention, wherein the field-generating device comprises a cylinder magnet, wherein the crystal is arranged in the cylinder magnet, such that the magnetic field vector encloses said angle with the defect-axis, particularly, wherein a cylinder axis of the cylinder magnet encloses the angle with the defect axis or the wherein the cylinder axis of the cylinder magnet is aligned with the defect axis.

The cylinder magnet may be a hollow cylinder magnet enclosing a cylinder volume in which the crystal is arranged.

The cylinder magnet may be a cylinder magnet with caps, i.e. a closed cylinder magnet. This embodiment would allow for robust gyroscopic applications.

In some embodiments the field-generating device consists of the cylinder magnet. In this case the cylinder axis may be oriented such that the magnetic field vector generated by the hollow cylinder magnet encloses said angle.

This embodiment allows for a robust sensing, as in essence, the color-center is exposed only to magnetic field components that are aligned with the magnetic field vector of the field-generating device, i.e. the color-center is shielded from transversal field components of external magnetic fields. Therefore, the system senses and determines magnetic field strength along the magnetic field vector of the field generating device.

Alternatively, or additionally, the field-generating device comprises a Halbach array and/or a solenoid coil.

In case the field-generating device comprises a Halbach array, the Halbach array may be shaped such that the magnetic field vector generated by the Halbach array encloses said angle with the defect-axis.

It is noted that the cylinder magnet may be formed by Halbach arrays, particularly such that a magnetic field at the crystal is increased and a magnetic field outside the cylinder is comparably weaker due to the Halbach geometry.

In case the field-generating device comprises a solenoid coil the magnetic field may be adjusted in strength, which allows to adjust the measurement sensitivity.

Further, according to another embodiment, the field-generating device comprises a permanent magnet, such as the cylinder magnet or the Halbach array, that has its magnetic field vector aligned with the defect-axis, and wherein the field-generating device, further comprises one or more solenoid coils that are arranged and configured to generate a transverse magnetic field component, such that the magnetic field vector of the field-generating device encloses said angle with the defect-axis. This allows electrically adjusting the angle of the magnetic field vector and the defect axis. According to another embodiment of the invention, the field-generating device, particularly, the cylinder magnet, the Halbach array and/or the solenoid coil, is/are dimensioned such that it shields the color-center from magnetic field vector components of an external magnetic field having a transversal orientation with respect to the magnetic vector generated by the field-generating device.

This embodiment further specifies the dimensions of the field-generating device, that are chosen according to the intended magnetic field distribution and magnetic field shielding properties for the crystal.

According to another embodiment of the invention, the color-center is arranged on a crystal lattice of the crystal, wherein the defect-axis is oriented along one of the crystal lattice axes, i.e. along an axis connecting two lattice atoms.

According to another embodiment of the invention, wherein the color-center comprises one or more groups of lattice members of C3v symmetry.

The term 'lattice member' in the context of the current specification particularly relates to the entities form the crystal lattice, e.g. atoms, molecules.

Many color-centers exhibit the C3v symmetry and are therefore suitable candidates for the system according to the invention. The defect atom may be placed in one of the group, wherein a second defect-atom or an associated vacancy may be placed in an adjacent group of lattice members. The defect-axis may be defined by a connecting line between the defect-atom and its associated second defect atom or vacancy in the adjacent group.

According to another embodiment of the invention, the color-center comprises a vacancy in the crystal lattice, wherein the vacancy is associated to the defect-atom, particularly wherein the defect-axis extends between the defect atom and the associated vacancy, particularly, wherein the associated vacancy is comprised in a first group of lattice members and the defect-atom is comprised in an adjacent second group of lattice members.

According to another embodiment of the invention, the color-center is devoid of a vacancy in the crystal lattice.

According to another embodiment of the invention, wherein the crystal comprises a plurality of color-centers, wherein each color-center has a defect-axis oriented along one of the axes of symmetry of the color-center, particularly along one of the axes of the crystal lattice, wherein the magnetic field vector of the magnetic field generated by the field-generating device encloses said angle only with defect-axes oriented along a selected axis of symmetry, particularly along a selected axis of the crystal lattice.

Having a plurality of color-centers allows for a higher signal, particularly a greater signal amplitude of the periodic variation and an increased robustness for the determination of the characteristic quantity.

As the system allows for a readout that is based on the periodic variation of the signal, color-centers oriented not in the angle range, but that enclose a greater angle with the static magnetic field vector, may contribute to an intensity of the signal but not to the periodic variation of the signal (as they are not initialized into the coherent superposition state), which increases robustness and reduces manufacturing costs for the crystal, as it is not necessary to have exactly one color-center, or all color-centers oriented along one symmetry or lattice axis.

According to another embodiment of the invention, the defect-axes of the plurality of color-centers are oriented preferentially along said selected axis of symmetry, particularly the selected axis of the crystal lattice, particularly wherein a majority of the plurality of color-centers has its defect-axes oriented along said selected axis.

The term 'preferentially' in the context of the current specification particularly refers to a distribution of orientations of defect-axes that differs from a uniform distribution along the symmetry or lattice axes. In a uniform distribution, all defect-axes would have the same probability to be oriented along one of symmetry or specifically the crystal lattice axes, wherein according to this embodiment, the probability of the defect-axes to be oriented along the selected axis of symmetry, particularly the selected axis of the crystal lattice, is higher than for the remaining other symmetry axes.

For example, in case the crystal lattice comprises four crystal lattice axes directions, then a preferential orientation along a selected axis of these four lattice axes would have a probability higher than 0.25.

According to this embodiment, the probability to be oriented along the selected axis may be in range from 0.4 to 1, particularly in the range from 0.5 to 0.8.

This embodiment allows for a higher signal to noise ratio, as a 'DC' contribution of color-centers having their defect-axes oriented along a symmetry axis that is not the selected axis, is reduced, which in turn increases the number of color-centers that provide the periodic varying photoluminescence signal ('AC' contribution).

According to another embodiment of the invention, the magnetic field generated by the field-generating device is between 400 and 600 Gauss.

In this field strength range, the system provides high-sensitivity and functionality.

According to another embodiment of the invention, the field-generating device is configured to generate a homogenous magnetic field at the crystal.

According to another embodiment of the invention, the detector comprises an optical detector configured to record a nuclear spin-dependent photoluminescent signal from the color center.

This embodiment allows to directly evaluate the photoluminescence of the color-center.

According to another embodiment of the invention, the detector is configured to record a nuclear spin-dependent electrical photo-current generated by the color-center, particularly wherein the detector comprises electrodes attached to the crystal.

This embodiment allows to address the electrical changes occurring the crystal induced by the photoluminescence characteristic. Such an electricity sensor is very cost-efficient and requires only minimal built space.

According to another embodiment of the invention, the light source comprises a light-generating device and a first optical fiber configured and arranged to collect the light from the light-generating device and to guide the collected light to the color-center for excitation.

This embodiment allows for a greater flexibility for arranging the light-generating device away from the color-center. The light may be guided by means of the first optical fiber to the color-center. This design allows for a particularly small sensor size.

According to another embodiment of the invention, the system further comprises a beam splitting element arranged such in the system that a photoluminescence signal collected from the crystal by the first fiber is split from the light generated by the light-generating device and guided to a detection unit of the detector, wherein said detection unit is configured to record the photoluminescence signal.

This embodiment allows for a greater flexibility for arranging the detection unit away from the color-center. The light may be guided by means of the first optical fiber to the detection unit of the detector. This design allows for a particularly small sensor size.

According to another embodiment of the invention, the detector comprises a second optical fiber configured and arranged to collect the photoluminescence signal from the color-center and to guide the collected photoluminescence signal to a detection unit configured and adapted to record the photoluminescence signal.

Both embodiments allow for a greater flexibility for arranging the detection unit away from the color-center. The light may be guided by means of the first or the second optical fiber to the detection unit. This design allows for a particularly small sensor size.

According to another embodiment of the invention, the system comprises a sensor head and a sensor base, wherein the sensor head comprises at least the crystal and the field-generating device, wherein the sensor base comprises either one or both of the following components of the system: the light-generating device and the detection unit, particularly wherein the sensor head is flexibly connected to the sensor base, more particularly, wherein the first and/or the second optical fiber connect the sensor head with the sensor base.

This embodiment allows for a very compact sensor head design, such that the sensor head may be introduced in small cavities.

As the crystal and the field-generating device do not require a lot of space, the sensor head may be built comparably small, particularly as the detector module is not part of the sensor head.

Particularly, the sensor head may comprise a volume in the range of 1 $\mu m^3$ or bigger.

According to another embodiment of the invention, the system comprises a control module configured to switch the light of the light source on and off.

The control module may be arranged at the sensor base.

According to another embodiment of the invention, the system, particularly the light source, is configured to excite the color-center into a state exhibiting an ESLAC in the magnetic field generated by the field-generating device.

According to another embodiment of the invention, the crystal is a diamond, the color-center is an NV-center, wherein the nitrogen atom is an $^{15}N$ isotope and the defect-axis extends from the defect-atom to the vacancy. Particularly, the NV-center is a negatively charged NV-center.

NV-centers are widely used as spin-based sensors and exhibit excitation and photoluminescence in the visible range, rendering the NV-centers particularly suitable for the system. NV-centers in diamonds also allow to be operated at room temperature.

Further, the excitation light may be in the range of 500 nm to 600 nm, wherein the detection of the photoluminescence signal may be performed in the wavelength range 600 nm to 800 nm.

An alternative to the NV-center in a diamond an NV center on SiC may be used. Here, the crystal is SiC and the color-center is the NV component like in the NV-center of the diamond.

It is further conceivable to use a SiV-center as the color-center and a diamond as the crystal comprising the SiV-center.

According to another embodiment of the invention, the crystal is an $Al2O_3$ crystal, and the color-center is a V2+ defect.

This crystal is an alternative crystal exhibiting advantageous properties for the system. Preferably, crystals with color-centers may be used that are operable at roomtemperature.

According to a second aspect of the invention, a method for measuring a characteristic quantity with a quantum spin-based optical sensor system, wherein the system comprises a crystal with a photoluminescent color-center having a defect-axis along an axis of symmetry of the color-center, wherein the color-center comprises a defect-atom arranged on the defect-axis, wherein the defect-atom exhibits a nuclear spin that is polarizable with light, and wherein the color-center exhibits a nuclear spin-dependent photoluminescence characteristic, wherein the method comprises the following measurement steps:

- During a spin initialization interval, exciting the color-center with light, particularly in a wavelength range between 200 nm and 2.5 micron, and exposing the color-center to a static magnetic field having a magnetic vector enclosing an angle ($\theta$) with the defect-axis, wherein said angle ($\theta$) has a magnitude greater than 0.1°, such that the nuclear spin of the defect-atom is initialized into a coherent quantum superposition state of the nuclear spin of the defect-atom, particularly wherein said angle is in the range of 0.1° to 10°, more particularly in the range of 0.1° and 5°, more particularly, in the range of 0.1° and 3°, particularly exposing the color-center also to the characteristic quantity,
- During a free precession interval of the coherent quantum superposition state of the nuclear spin of the defect-atom, exposing the color-center to the static magnetic field and the characteristic quantity to be measured, while suppressing excitation of the color-center with light,
- During a nuclear spin readout interval, exciting the color-center with light, and recording at least one value from the nuclear spin-dependent signal from the color-center, particularly exposing the color-center to the static magnetic field and the characteristic quantity to be measured.

Definitions and terms as well as embodiments disclosed in the context of the first aspect of the invention may be applied to the second aspect of the invention, and vice versa.

Therefore, the magnetic field generated by the field-generating device is constant and static.

The method according to the second aspect allows to measure and determine the characteristic quantity, such as a magnetic field strength precisely and in a robust fashion.

As elaborated in previous paragraphs of the current specification, the method induces a periodically varying photoluminescence signal in the color-center, wherein the period resp. a frequency of the periodic variation is a direct measure of the characteristic quantity, such as the magnetic field.

Particularly, the method addresses the ESLAC of the nuclear spin of the defect-atom. According to another embodiment of the invention, the spin-initialization interval has a duration between 1 $\mu$s and 50 $\mu$s.

According to another embodiment of the invention, the free precession interval has a duration between 1 $\mu$s and 2 ms.

According to another embodiment of the invention, the nuclear spin readout interval has a duration between 50ns and 5 $\mu$s.

According to another embodiment of the invention, the method is executed with a system according to the first aspect.

According to a third aspect of the invention, a computer program is disclosed that comprises computer program code that when executed on a computer executes the method according to the second aspect on a system according to the first aspect, wherein the computer program is configured to issue control commands via at least one interface of the computer to the components of the system and to receive signals from the components of the system.

Particularly, the computer program is stored on a non-transitory computer-readable storage medium.

Particularly, the components comprise the light source, the controller module, the evaluation module, the detector.

According to a fourth aspect of the invention, a computer program product in form of a non-transitory computer-readable storage medium having stored thereon the computer program according to the third aspect is disclosed.

Figure description and exemplary embodiments

Particularly, exemplary embodiments are described below in conjunction with the Figures. The Figures are appended to the claims and are accompanied by text explaining individual features of the shown embodiments and aspects of the present invention. Each individual feature shown in the Figures and/or mentioned in said text of the Figures may be incorporated (also in an isolated fashion) into a claim relating to the device according to the present invention.

Fig. 1     shows a schematic view of the color-center, the direction of the nuclear spin and the static magnetic field;

Fig. 2     shows method steps and measurement data;

Fig. 3     shows a first exemplary embodiment according to the invention;

Fig. 4     shows a second exemplary embodiment according to the invention;

Fig. 5     shows the FID-contrast of the system in dependency of the angle.

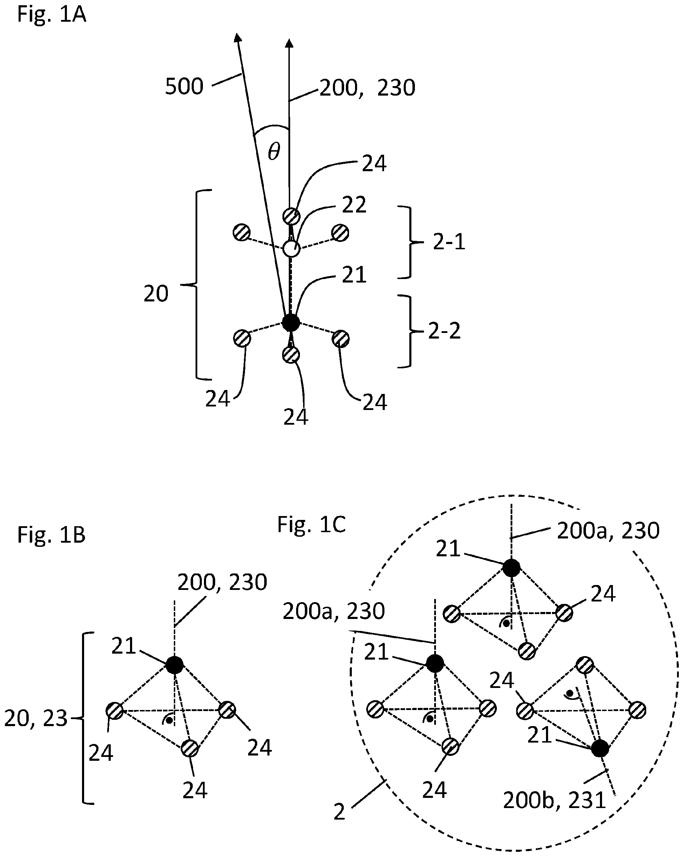

In Fig. 1A, B and C schematic drawings of some components of an exemplary embodiment of the system 1 according to the invention is shown.

Fig. 1 depicts a spin-dependent photoluminescent color-center 20 in a crystal lattice 23 formed by lattice atoms 24 (depicted as hatched circles), wherein the crystal lattice 23 comprises a defect-atom 21 (depicted as a black circle) and a vacancy 22 (depicted as a white circle). Such a color-center 20 may be an NV-center of a diamond or an NV-center in SiC. The NV-center is thus formed by the defect-atom 21 and the associated vacancy 22.

The broken lines between the atoms and the vacancy illustrate the crystal lattice geometry, which in this case exhibits a C3v symmetry. The defect-atom 21 is comprised in a first group of lattice members 2-1, wherein the vacancy 22 is comprised in a second group of lattice members 2-2, wherein each group exhibits a C3v symmetry.

A symmetry axis of the first group of lattice members 2-1 extends between the defect-atom 21 towards the vacancy 22 of the second group of lattice members 2-2. At the same time the symmetry axis corresponds to a symmetry axis of the second group of lattice members 2-2.

This symmetry axis is considered as the defect-axis 200.

It is noted that a symmetry axis and thus a defect-axis 200 may be defined also in the absence of a vacancy 22 or in absence of a second defect-atom, but by the lattice symmetry, as shown in Fig. 1B. Fig. 1B exemplarily depicts a C3v symmetry group with a symmetry axis that is defined by the axis that extends through the defect atom 21 and orthogonally to a plane comprising the three remaining lattice members (lattice atoms). In Fig. 1C, a crystal 2 is depicted that comprises a plurality of color-centers 20 (formed by a single defect atom 21 each), wherein two color centers 20 have their defect axis 200a along a selected the lattice axis 230 and one of the color centers 20 has its defect-axis 200b along a different lattice axis 231 of the crystal 2.

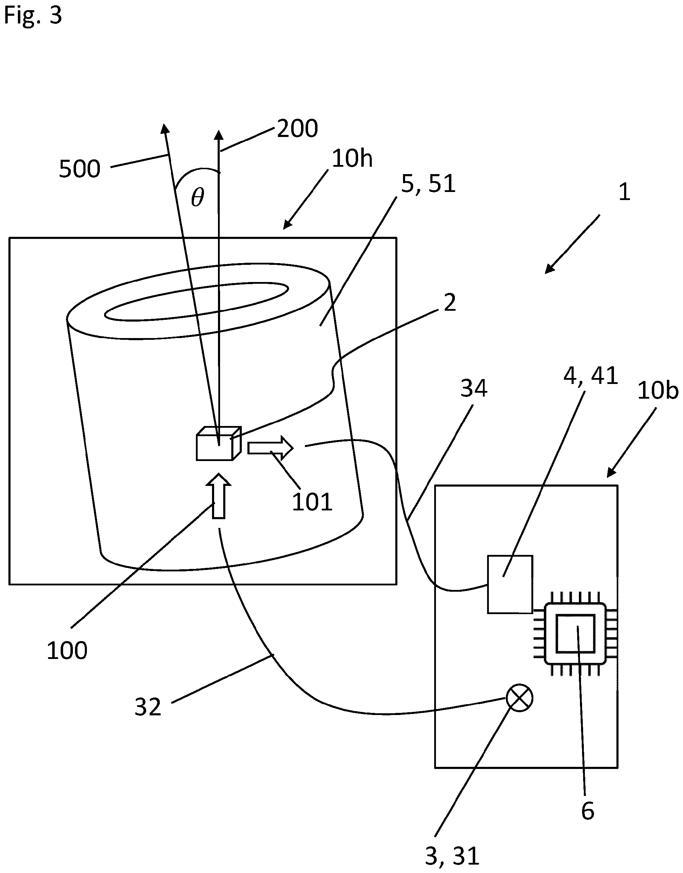

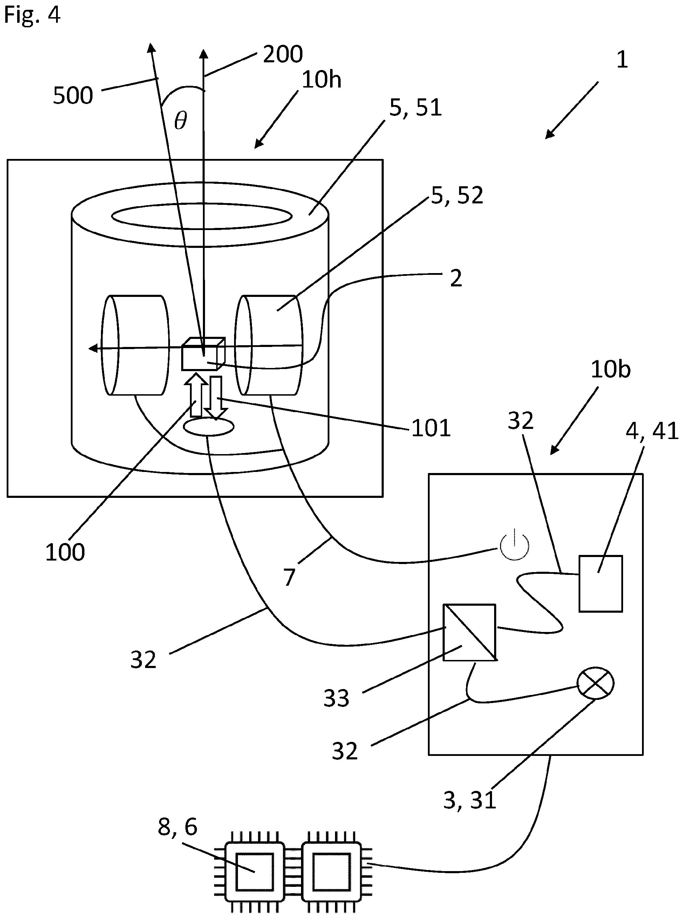

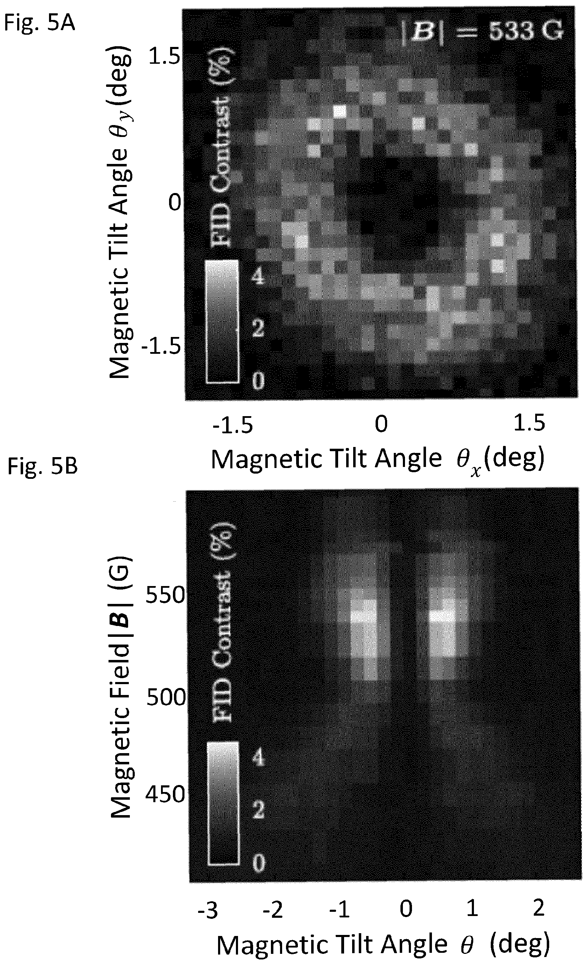

In relation to Fig. 1A, the system 1 comprises a field-generating device 5 and a light source 3 (cf. e.g. Fig. 3 and 4) that initialize the nuclear spin of the defect-atom 21 into a coherent quantum superposition state. This is achieved by orienting the static magnetic field generated by the field-generating device 5, such that a magnetic field vector 500 of the magnetic field at the defect-atom 21 encloses an angle $\theta$ in the range of 0.1° to 3° with the defect-axis 200 (a viable range of angles $\theta$ is depicted in Fig. 5). Having the static magnetic field oriented accordingly, the color-center 20 may be optically initialized by exciting, e.g. pumping the defect-atom 21 with the light source 3 into said coherent quantum superposition state. Once the nuclear spin is initialized into this state, the light 100 is turned off for a free precession interval t2 in which the color-center 20 may be exposed to a characteristic quantity that is to be measured. Said characteristic quantity may be a magnetic field strength of an external magnetic field. The color-center 20 may be exposed to the characteristic quantity already during the spin initialization interval t1, but not necessarily so.

After the free precession interval t2, the spin precession is read out t3 all optically by illuminating the color-center 20. The photoluminescent signal 101 that is emitted by the color-center 20, is by choice of the color-center 20 spin dependent. As the spin precesses, the photoluminescent signal 101 reflects this precession by a periodic intensity variation. This periodic variation in turn is recorded by the detector 4. As the period of the photoluminescence signal 101 depends for example on the magnetic field, the frequency or the period of said signal 101 are a direct measure for the magnetic field strength of static and the external magnetic field. As the static magnetic field strength is known, any change of frequency allows to determine the field strength of the external magnetic field.

The magnetic field strength may be obtained by the following formula:

$$f_{nuc} = \sqrt{(\gamma_I B_z + \omega)^2 + (\gamma_I B_\perp + \Omega)^2} \qquad \text{(Eq. 1)}$$

Wherein $f_{nuc}$ is the frequency of the periodic photoluminescence variation, $\gamma_I$ is the gyromagnetic ratio of the defect-atom, $B_z$ is the magnetic field along the defect-axis, and $B_\perp$ is the transversal magnetic field strength, $\omega$ is the Lamor-frequency, and $\Omega$ is a correction term accounting for the electronic spin and zero-field splittings.

As can be seen, the frequency of the optical signal is directly related to the magnetic field strength at the defect-atom.

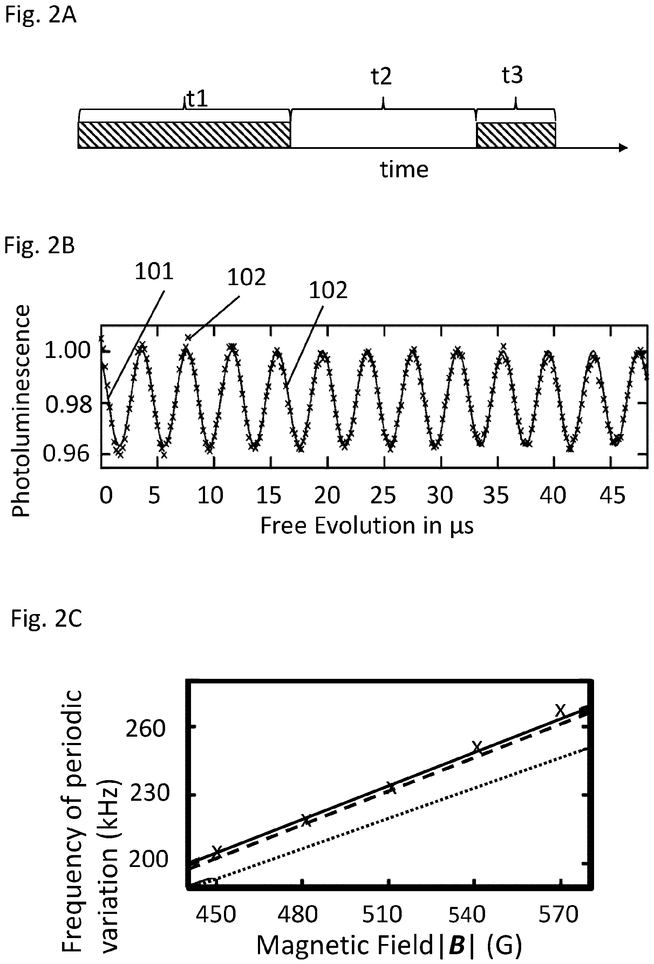

For an NV-center in a diamond exposed to a static magnetic field vector enclosing 1° angle $\theta$ with the defect axis, and a magnetic field strength of |B|= 540 G said frequency is determined to be around 251.18 kHz (cf. extracted from fitted line (solid line, signal 101) to the recorded value 102 (black crosses) in Fig. 2B). An additional external magnetic field to which the color-center is exposed will alter said frequency. In Fig. 2A the sequence of the method step that may be executed on the system is schematically depicted. The spin initialization interval t1 may take 3 $\mu$s, wherein the interval duration is not critical as long as it is long enough to initialize the nuclear spin of the defect atom into the coherent quantum superposition state. Subsequently, the light 100 is turned off for an adjustable duration, allowing a free precession of the spin to happen. Then, to read-out the precession frequency, the light is turned on again and the periodically varying photoluminescence signal 101 is recorded (Fig. 2B) for a spin readout interval t3 that is in the range of several nanoseconds, but at least long enough to sample the periodic frequency of the signal 101. The duration may be in the range of 350 ns or longer.

Fig. 2C shows the linear dependency of the frequency of the photoluminescence signal 101 on the magnetic field |B|, at an angle of 1°. The solid line represents the predictions of Eq. 1, the broken line is a numeric simulation (cf. data represented as crosses in Fig. 2B) and the dotted line represents the bare Larmor frequency $\gamma_I B_z$. Fitting the data with a linear function (not shown) reveals a slope of 5.176 MHz/T.

Thus, by determining the periodic variation of the recorded photoluminescence signal 101, the frequency of said variation may be determined allowing the determination of the magnetic field at the defect-atom 21.

However, it is not strictly necessary to record or sample the whole periodic variation (or even one full period), a two-value 102 measurement may suffice, where the precession interval duration is fixed at two selected durations. For instance, for the data in Fig. 2B, the durations could be chosen as 44 $\mu$s and 46 $\mu$s - the difference between the signal values 102 at these times for small changes in magnetic field will show a linear dependence on magnetic field (in a background and drift-free manner).

In Fig. 3 an exemplary embodiment of the system 1 according to the invention is schematically depicted. The system 1 comprises a crystal 2 having at least one color-center 20. It may be advantageous if the crystal 2 comprises a plurality of color-centers 20, wherein the defect-axes 200a, 200b of the color-centers 20 may be preferentially aligned along one selected common direction of the crystal 230. The plurality of color-centers 20 will yield a more robust system having a higher signal to noise ratio in its free induction decay contrast (FID contrast).

The system 1 in this embodiment comprises a permanent cylinder magnet 51 as a field generating device 5, having its north and south pole oriented such with respect to the selected axis 230 that the magnetic field vector 500 of the cylinder magnet 51 encloses the angle $\theta$ in the range of 0.1° to 3°.

The cylinder magnet 51 and the crystal 2 are comprised in a sensor head 10h of the system 1, wherein a first optical fiber 32 is connected such to the sensor head 10h that illumination and excitation of the crystal 2 by light 100 is achieved, by guiding the light 100 through the first fiber 32 and shine the light 100 onto the crystal 2. The system 1 in Fig. 3 further comprises a second optical fiber 34 that is configured to collect the photoluminescence 101 emitted by the one or more color-centers 20. For this purpose, the system 1 may comprise an optical filter (not shown) that blocks light in the excitation wavelength range, such that excitation light 100 is not guided to the detector 4, but only the photoluminescence signal 101.

The first optical fiber 32 and the second optical fiber 34 may guide the light 100 out of the sensor head 10h to a sensor base 10b of the system 1, wherein the sensor base 10b comprises a detection unit 41 that detects and records the photoluminescence 101 emitted at one end from the second optical fiber 34. The sensor base 10b further comprises a light-generating device 31, such as an LED for exciting the color-center 20. The sensor base 10b is therefore flexibly connected to the sensor head 10h. The sensor head 10h comprises only small additional optical components (e.g. collimating or coupling optics) the crystal 2 and the permanent magnet 51. Therefore, the sensor head 10h may sense the characteristic quantity without an additional electric power source or electric or electromagnetic device and can be built comparably small.

The sensor base 10b may comprise components that require electricity, but as the sensor base 10b is arranged away from the sensor head 10h, the system 1 allows sensing with the sensor head 10h in small cavities. The sensor base 10b may further comprise a processing or evaluation module 6 configured to process and/or store the recorded photoluminescence signal 101. The processor 6 may be used as a control module that controls the light source 3 and the detector 4.

In Fig. 4 a variation of the system 1 according to the invention is shown, wherein in contrast to the embodiment of Fig. 3, this embodiment has a field-generating device 5 comprising two magnets: A permanent cylinder magnet 51 arranged with its magnetic field vector along the defect axis 200 and a coil arrangement of solenoid coils, for generating a transversal magnetic field such that at the defect-atom 21 the resulting magnetic field vector 500 of the field-generating device 5 encloses said angle. This embodiment allows for adjusting the angle $\theta$ of the magnetic field vector 500 with respect to the defect axis 200 for adjusting the sensitivity of the system 1.

Further, in contrast to the embodiment of Fig. 3, the system 1 in Fig. 4 comprises only one optical fiber 32 that is configured to guide the light from the light-generating device 3 to the crystal 2 and to collect the photoluminescence light 101 from the crystal 2. In the sensor base 10b, a beam splitter 33, e.g. a dichroic beam splitter or beam combiner, is arranged that separates or combines the light 100, such that the detector 4 is exposed inly to the photoluminescence signal 101 and the light 100 from the light-generating device 31 is guided to the crystal 2.

Further, an electric power cable 7 is connected to the coil arrangement for providing electricity to the coil arrangement 52. The electric current may be adjusted for adjusting the transversal magnetic field and thus the angle $\theta$.

It is noted that the sensor head 10h design is largely independent of the sensor base 10b design, i.e. whether the system 1 has one or two optical fibers is independent of the orientation of the permanent magnet in the sensor head. The two designs of Fig. 3 and 4 are therefore partially interchangeable.

The system 1 in Fig. 4 comprises a connection from the sensor base 10b to an external computer 8 of the system 1 which may be configured to control the system 1, particularly via a computer program that is configured to execute the method steps.

Fig. 5A shows a dependency of the angle $\theta$ (with transversal angle components in the x-and y-plane, if the defect-axis extends along a z-axis of a cartesian coordinate system) enclosed between the magnetic field vector and a resulting FID-contrast for a field strength of 533 G. as can be seen, at an angle of 0°, the FID contrast is zero, as no periodic variations would occur.

Fig. 5B shows a dependency of the angle $\theta$ (with transversal angle components in one of the x- or y-plane, if the defect-axis extends along a z-axis of a cartesian coordinate system) enclosed between the magnetic field vector and a resulting FID-contrast for different magnetic field strength for an $^{15}$NV-center in a diamond.

Theory

A negatively charged NV-center of a diamond possesses an electronic spin S = 1 quantized along the NV symmetry axis 'z', also referred to as defect-axis in the current specification. In addition, for NV-centers formed by $^{15}$N, the Nitrogen nucleus possesses a spin I = 1/2. Using the electronic spin operators **S** and the nuclear spin operator **I**, the Hamiltonian for the NV's orbital ground (*gs*) and excited state (*es*) can be expressed as

$$\hat{H}^{gs,es}/\hbar = D_0^{gs,es}\hat{S}_z^2 + \hat{\boldsymbol{S}} \cdot \boldsymbol{A}^{gs,es} \cdot \hat{\boldsymbol{I}} + \gamma_S \boldsymbol{B} \cdot \hat{\boldsymbol{S}} + \gamma_I \boldsymbol{B} \cdot \hat{\boldsymbol{I}} \qquad \text{(Eq. 2)}$$

Here, $D_0^{gs} = 2.87$ GHz, $D_0^{es} = -1.415$ GHz are the respective the zero-field splittings, **B** is the applied magnetic field, $\gamma_S = 28.024$ GHz/T and $\gamma_I = 4.316$ MHz/T are the respective gyromagnetic ratios and $\boldsymbol{A}^{gs,es}$ is the diagonal hyperfine coupling tensor with two independent components $A_\parallel^{gs}$ = 3.65 MHz and $A_\perp^{gs}$ = −3.03 MHz , and

$A_\parallel^{es} = A_\perp^{es} =$ 60 MHz respectively. Hamiltonian (Eq. 2) conveniently expressed in a basis of single-spin states {$|m_S$, $m_I\rangle$}, where $m_S$ and $m_I$ are the projection quantum number of $\hat{S}$ and $\hat{I}$ onto the z-axis.

The coherent FID dynamics (Fig. 2B) studied in this work occurs in the two-level ground state subspace spanned by{$|0, -1/2\rangle$, $|0, +1/2\rangle$}. Near the ESLAC, with a magnetic field $\boldsymbol{B}$ = (0, 0, $B_z$) aligned with the defect-axis, and when illuminated by green light, the NV's optical excitation and relaxation dynamics causes this subsystem to be initialized into the eigenstate $|0, -1/2\rangle$. Thus, once optical excitation is turned off, the optically pumped system would then decay to thermal equilibrium, without any coherent dynamics taking place. In stark contrast to this, the $^{15}$N spin exhibits FID dynamics after optical pumping once a small transverse magnetic field $B_\perp$ is introduced. In the following paragraphs we explain the nuclear precession data presented in Fig. 2B by discussing how the presence of $B_\perp$ significantly changes the dynamics of both the system's optical pumping and its subsequent free evolution (free precession).

We start by calculating an effective Hamiltonian for the $^{15}$N spin the electronic $m_S$ = 0 ground state subspace. Such an effective Hamiltonian can be calculated using Van Vleck perturbation theory. This derivation yields the following result:

$$H_{\text{eff}}^{m_S=0} = \begin{bmatrix} \gamma_I B_z + \omega & \gamma_I B_\perp + \Omega \\ \gamma_I B_\perp + \Omega & -\gamma_I B_z - \omega \end{bmatrix} \qquad \text{(Eq. 3)}$$

where

$$\omega = \frac{\gamma_s B_z \left(A_\perp^{gs}\right)^2}{\left(D_0^{gs}\right)^2 - (\gamma_s B_z)^2} \qquad \text{(Eq. 4)}$$

denotes the correction to the diagonal elements caused by mixing between states of different $m$, and

$$\Omega = -\gamma_s B_\perp A_\perp^{gs} \left( \frac{1}{D_0^{gs} + \gamma_s B_z} + \frac{1}{D_0^{gs} - \gamma_s B_z} \right) \qquad \text{(Eq. 5)}$$

is the corresponding correction to the off-diagonal elements.

The eigenvalues of $H_{eff}^{m_S=0}$ then directly yield the precession frequency of the $^{15}$N spin as given in Eq. 1:

$$f_{nuc} = \sqrt{(\gamma_I B_z + \omega)^2 + (\gamma_I B_\perp + \Omega)^2}$$

Importantly, even in the absence of transverse magnetic fields (i.e. for $B_\perp$ = 0), $f_{nuc}$ exceeds the bare $^{15}$N nuclear precession frequency $\gamma_I B_z$ by $\omega$. Furthermore, Eq. (3) also yields the well-known enhancement of the transverse nuclear g-factor, as well as the orientation of the quantization axis of the $^{15}$N nuclear spin, which lies in the x-z plane, tilted away from the z-axis by the angle $\theta$ = tan$^{-1}$[($\gamma_I B_\perp$ + $\Omega$)/($\gamma_I B_z$ + $\omega$)]. It thus is not collinear with $\boldsymbol{B}$ unless $B_\perp$ = 0.

We now analyze how the presence of a small transverse field $B_\perp$ = affects the $^{15}$N spin dynamics and enables all-optical initialization into a coherent nuclear spin superposition state. In the presence of $B_\perp$, apart from the tilted $^{15}$N nuclear spin quantization axis in the NV's orbital ground state, the NV's orbital excited state exhibits yet another $^{15}$N nuclear spin quantization direction, due to the vastly different hyperfine parameters in the NV's orbital ground and excited states and the vicinity to the ESLAC. This difference in $^{15}$N nuclear spin quantization axes results in optical pumping of the nuclear spin into a steady state that does not correspond to an eigenstate of $H_{\text{eff}}^{m_S=0}$. As an initial approximation, we expect the optical pumping process to cause accumulation of NV excited state population in the state with largest overlap with $|m_S = 0\rangle_{es}$ because this state has the slowest shelving rate into the NV's electronic singlet state - we denote this "brightest" state as $|\tilde{0}\rangle_{es}$

The steady state orientation of the $^{15}$N nuclear spin under green illumination should then be $\langle \tilde{0}_{es}|\hat{I}|\tilde{0}\rangle_{es}$. Since

$|\hat{0}\rangle_{es}$ is not in general an eigenstate of $H_{\text{eff}}^{m_S=0}$, after optical pumping (i.e. once optical excitation is turned off) the $^{15}$N spin should exhibit precession around an effective magnetic field $\boldsymbol{B}_{\text{eff}}$ that is given by $H_{\text{eff}}^{m_S=0}$.

References

[1] Arne Wickenbrock, Huijie Zheng, Lykourgos Bougas, Nathan Leefer, Samer Afach, Andrey Jarmola, Victor M. Acosta, and Dmitry Budker, "Microwave-free magnetometry with nitrogen-vacancy centers in diamond", Appl. Phys. Lett. 109, 053505 (2016) https://doi.org/10.1063/1.4960171

Reference signs

| | |
|---|---|
| 1 | system |
| 10b | sensor base |
| 10h | sensor head |
| 2 | crystal |
| 20 | color-center |
| 21 | defect-atom |
| 22 | vacancy |
| 23 | crystal lattice |
| 24 | lattice atoms |
| 2-1 | first group of lattice members |
| 2-2 | second group of lattice members |
| 3 | light source |
| 31 | light generating device |
| 32 | first optical fiber |
| 33 | beam splitting element |
| 34 | second optical fiber |
| 4 | detector |
| 41 | detection unit |
| 5 | field-generating device |
| 51 | cylinder magnet |
| 52 | solenoid coil |
| 6 | evaluation module |
| 7 | cable |
| 8 | external computer |
| t1 | spin initialization interval |
| t2 | free precession interval |
| t3 | spin readout interval |
| 100 | excitation light |
| 101 | photoluminescence signal |
| 102 | value of signal |
| 200 | defect-axis |
| 200a, 200b | defect axis |
| 230, 231 | axis of the crystal lattice |
| 230 | selected axis |
| 500 | magnetic field vector |
| $\theta$ | angle |

**Claims**

1. A quantum spin-based optical sensor system (1) for measuring a characteristic quantity in magnetometry or gyroscopy, the system (1) comprising the following components:

   - a crystal (2) comprising a photoluminescent color-center (20) having a defect-axis (200) along an axis of symmetry of the color-center (20), wherein the color-center (20) comprises a defect-atom (21) arranged on the defect-axis (200), wherein the defect-atom (21) exhibits a nuclear spin that is polarizable with light (100), and wherein the color-center (20) exhibits a nuclear spin-dependent photoluminescence characteristic,
   - a light source (3) configured and arranged to excite the color-center (20) with light (100),
   - a detector (4) configured and arranged to record a nuclear spin-dependent signal (101) from the color-center (20),
   - a field-generating device (5) configured and adapted to generate a static magnetic field, wherein a magnetic field vector (500) of the generated magnetic field at the crystal (2) encloses an angle ($\theta$) with the defect-axis (200) having a magnitude greater than 0.1° such that the nuclear spin-dependent signal (101) exhibits a periodic variation, when the color-center has been optically initialized by the light source (3) into a coherent quantum superposition state.

2. The system (1) according to claim 1, wherein the system (1) is configured to determine the characteristic quantity by executing the measurement steps of:

   - During a spin initialization interval (t1), exciting the color-center (20) with light (100) of the light source (3) and exposing the color-center (20), particularly the crystal (2), to the magnetic field of the field-generating device (5), such that the nuclear spin of the defect-atom (21) is initialized into the coherent quantum superposition state, particularly wherein the coherent quantum superposition state differs from an eigenstate of the nuclear spin of the defect-atom,
   - During a free precession interval (t2), exposing the color-center (20), particularly the crystal (2), to the magnetic field of the field-generating device (5) and the characteristic quantity to be measured, while suppressing excitation of the color-center (2) with light (100) from the light source (3),
   - During a nuclear spin readout interval (t3), exposing the color-center (20), particularly the crystal (2), to the magnetic field of the field-generating device (5), exciting the color-center (20) with light (100) from the light source (3), and recording at least one value (102) of the nuclear spin-dependent signal (101) from the color-center (20) with the detector (4).

3. The system (1) according to claim 2, wherein the system (1) comprises an evaluation module (6) configured to determine a periodic variation from the recorded nuclear spin-dependent signal (101), wherein the periodic variation is determined by executing the measurement steps for two or more different durations of the free precession interval (t2) and by determining the periodic variation from the recorded values (102) of the nuclear spin-dependent signal, and to determine from the periodic variation the characteristic quantity.

4. The system (1) according to one of the preceding claims, wherein the magnitude of the angle ($\theta$) is in the range of 0.1° to 10°, particularly in the range of 0.1° to 5°, more particularly in the range of 0.1° to 3°.

5. The system (1) according to any of the preceding claims, wherein the field-generating device (5) comprises a cylinder magnet (51), wherein the crystal (2) is arranged in the cylinder magnet (51), such that the magnetic field vector (500) encloses said angle ($\theta$) with the defect-axis (200), particularly, wherein a cylinder axis of the cylinder magnet (51) encloses the angle ($\theta$) with the defect-axis (200).

6. The system (1) according to one of the preceding claims, wherein the field-generating device (5) comprises a Halbach array and/or a solenoid coil (52), and/or a flat, permanent magnet on whose surface the color-center containing crystal is placed.

7. The system (1) according to one of the preceding claims, wherein the color-center (20) is arranged on a crystal lattice (23) of the crystal (2), wherein the defect-axis (200) is oriented along one of the crystal lattice axes (230, 231).

8. The system (1) according to claim 7, wherein the color-center (20) comprises one or more groups of lattice members (2-1,2-2) of C3v symmetry.

9. The system (1) according to one of the claims 8, wherein the color-center (20) comprises a vacancy (22) in the crystal lattice (23), wherein the vacancy (22) is associated to the defect-atom (21), particularly wherein the defect-axis (200) extends between the defect-atom (21) and the vacancy (22), particularly, wherein the vacancy (22) is comprised in a first group of lattice members (2-1) and the defect-atom (21) is comprised in an adjacent second group of lattice members (2-2).

10. The system (1) according to any of the preceding claims, wherein the crystal (2) comprises a plurality of color-centers (20), wherein each color-center (20) has a defect-axis (200a, 200b) oriented along one of the axes of symmetry of the color-center (20), particularly along one of the axes of the crystal lattice (230, 231), wherein the magnetic field vector (500) of the magnetic field generated by the field-generating device (5) encloses said angle ($\theta$) only with defect-axes (200) oriented along a selected axis of symmetry, particularly along a selected axis of the crystal lattice (230).

11. The system (1) according to claim 10, wherein the defect-axes (200a, 200b) of the plurality of color-centers (20) are oriented preferentially along said selected axis (230), particularly wherein a majority of the plurality of color-centers (20) has its defect-axes (200a, 200b) oriented along said selected axis (230).

12. The system (1) according to one of the preceding claims, wherein the light source (3) comprises a light-generating device (31) and a first optical fiber (32) configured and arranged to collect the light (100) from the light-generating device (51) and to guide the collected light (100) to the color-center (20) for excitation.

13. The system according to one of the preceding claims, wherein the detector (4) is an optical detector, configured to record a nuclear spin-dependent photoluminescent signal from the color center (20), or wherein the detector (4) is configured to record a nuclear spin-dependent electrical photo-current generated by the color-center, particularly wherein the detector (4) comprises electrodes attached to the crystal (2).

14. The system (1) according to claim 12 or 13, wherein the system (1) comprises a sensor head (10h) and a sensor base (10b), wherein the sensor head (10h) comprises at least the crystal (2) and the field-generating device (5), wherein the sensor base (10b) comprises either one or both: the light-generating device (31) and the detector (4).

15. A method for measuring a characteristic quantity with a quantum spin-based optical sensor system, wherein the system comprises a crystal with a photoluminescent color-center having a defect-axis along an axis of symmetry of the color-center, wherein the color-center comprises a defect-atom arranged on the defect-axis, wherein the defect-atom exhibits a nuclear spin that is polarizable with light, and wherein the color-center exhibits a nuclear spin-dependent photoluminescence characteristic, wherein the method comprises the following measurement steps:

- During a spin initialization interval, exciting the color-center with light and exposing the color-center to a static magnetic field having a magnetic vector enclosing an angle ($\theta$) with the defect-axis, wherein said angle ($\theta$) has a magnitude greater than 0.1°, such that the nuclear spin of the defect-atom is initialized into a coherent quantum superposition state of the nuclear spin of the defect-atom,
- During a free precession interval of the coherent quantum superposition state of the nuclear spin of the defect-atom, exposing the color-center to the static magnetic field and the characteristic quantity to be measured, while suppressing excitation of the color-center with light,
- During a nuclear spin readout interval, exposing the color-center to the magnetic field of the field-generating device, exciting the color-center with light, and recording at least one value (102) from the nuclear spin-dependent signal from the color-center.

Fig. 1A

Fig. 1B

Fig. 1C

Fig. 2A

Fig. 2B

Fig. 2C

Fig. 3

Fig. 4

Fig. 5A

Fig. 5B

Europäisches
Patentamt

European
Patent Office

Office européen
des brevets

# EUROPEAN SEARCH REPORT

Application Number

EP 22 19 9322

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/307997 A1 (MEIJER JAN BEREND [DE] ET AL) 29 September 2022 (2022-09-29) | 1,2,4-15 | INV. G01R33/032 G01R33/26 |
| A | * paragraphs [0301] - [0317], [0588] - [0603]; figures 27-30 * | 3 | |
| X | ZIWEI QIU ET AL: "Nuclear Spin Assisted Magnetic Field Angle Sensing", ARXIV.ORG, CORNELL UNIVERSITY LIBRARY, 201 OLIN LIBRARY CORNELL UNIVERSITY ITHACA, NY 14853, 8 October 2020 (2020-10-08), XP091180163, DOI: 10.1038/S41534-021-00374-6 * the whole document * | 1,2,4-15 | |
| X | ALEXANDER A WOOD ET AL: "Quantum control of nuclear spin qubits in a rapidly rotating diamond", ARXIV.ORG, CORNELL UNIVERSITY LIBRARY, 201 OLIN LIBRARY CORNELL UNIVERSITY ITHACA, NY 14853, 27 July 2021 (2021-07-27), XP091017271, * the whole document * | 1,2,4-15 | TECHNICAL FIELDS SEARCHED (IPC) G01R |
| A | HUILLERY P ET AL: "Coherent Microwave Control of a Nuclear Spin Ensemble at Room Temperature", ARXIV.ORG, CORNELL UNIVERSITY LIBRARY, 201 OLIN LIBRARY CORNELL UNIVERSITY ITHACA, NY 14853, 27 May 2020 (2020-05-27), XP081684109, * the whole document * | 1-15 | |

-/--

The present search report has been drawn up for all claims

| Place of search | Date of completion of the search | Examiner |
|---|---|---|
| Munich | 17 March 2023 | Philipp, Peter |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................

& : member of the same patent family, corresponding document

EPO FORM 1503 03.82 (P04C01)

Europäisches
Patentamt

European
Patent Office

Office européen
des brevets

# EUROPEAN SEARCH REPORT

**Application Number**

**EP 22 19 9322**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ALEXANDER A WOOD ET AL: "Anisotropic electron-nuclear interactions in a rotating quantum spin bath", ARXIV.ORG, CORNELL UNIVERSITY LIBRARY, 201 OLIN LIBRARY CORNELL UNIVERSITY ITHACA, NY 14853, 16 May 2021 (2021-05-16), XP081963716, * the whole document * | 1-15 | |
| A | RONDIN L ET AL: "Nanoscale magnetic field mapping with a single spin scanning probe magnetometer", ARXIV.ORG, CORNELL UNIVERSITY LIBRARY, 201 OLIN LIBRARY CORNELL UNIVERSITY ITHACA, NY 14853, 22 August 2011 (2011-08-22), XP080522276, DOI: 10.1063/1.3703128 * the whole document * | 1-15 | |

| | | | TECHNICAL FIELDS SEARCHED (IPC) |
|---|---|---|---|

The present search report has been drawn up for all claims

| Place of search | Date of completion of the search | Examiner |
|---|---|---|
| Munich | 17 March 2023 | Philipp, Peter |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 19 9322

17-03-2023

| Patent document cited in search report | Publication date | Patent family member(s) | Publication date |
|---|---|---|---|
| US 2022307997 A1 | 29-09-2022 | DE 102020119414 A1 | 28-01-2021 |
| | | DE 112020003569 A5 | 28-04-2022 |
| | | DE 202020106110 U1 | 03-12-2020 |
| | | DE 202020106145 U1 | 11-11-2020 |
| | | EP 3980797 A1 | 13-04-2022 |
| | | US 2022307997 A1 | 29-09-2022 |
| | | WO 2021013308 A1 | 28-01-2021 |

EPO FORM P0459

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **ARNE WICKENBROCK ; HUIJIE ZHENG ; LYKOURGOS BOUGAS ; NATHAN LEEFER ; SAMER AFACH ; ANDREY JARMOLA ; VICTOR M. ACOSTA ; DMITRY BUDKER.** Microwave-free magnetometry with nitrogen-vacancy centers in diamond. *Appl. Phys. Lett.,* 2016, vol. 109, 053505, https://doi.org/10.1063/1.4960171